(19) Europäisches Patentamt
European Patent Office
Office européen des brevets

(11) Veröffentlichungsnummer: **0 210 437 B1**

(12) **EUROPÄISCHE PATENTSCHRIFT**

(45) Veröffentlichungstag der Patentschrift: **04.09.91**

(51) Int. Cl.$^5$: **C23C 18/18**

(21) Anmeldenummer: **86108645.2**

(22) Anmeldetag: **25.06.86**

Die Akte enthält technische Angaben, die nach dem Eingang der Anmeldung eingereicht wurden und die nicht in dieser Patentschrift enthalten sind.

# (54) Verfahren zur chemischen Metallisierung eines elektrisch schlecht leitenden Trägerkörpers aus einem anorganischen Material.

(30) Priorität: **04.07.85 DE 3523956**

(43) Veröffentlichungstag der Anmeldung:
**04.02.87 Patentblatt 87/06**

(45) Bekanntmachung des Hinweises auf die Patenterteilung:
**04.09.91 Patentblatt 91/36**

(84) Benannte Vertragsstaaten:
**AT BE CH DE FR GB IT LI LU NL SE**

(56) Entgegenhaltungen:
**EP-A- 0 035 626**
**DE-A- 2 533 524**

**IBM TECHNICAL DISCLOSURE BULLETIN, Band 14, Nr. 10, März 1972, Seite 2856, New York, US; P. BAKOS: "Ceramic substrate circuitization"**

**Handbuch der Galvanotechnik, Band I, Teil 2 (1964), Seiten 1136, 1137**

(73) Patentinhaber: **Licentia Patent-Verwaltungs-GmbH**
**Theodor-Stern-Kai 1**
**W-6000 Frankfurt/Main 70(DE)**

(72) Erfinder: **Bogenschütz, August-Friedrich, Dr.rer.nat**
**Beethovenstrasse 10**
**W-7931 Oberdischingen(DE)**
Erfinder: **Jostan, Josef L., Dr.rer.nat.**
**Haslacherweg 21**
**W-7900 Ulm(DE)**
Erfinder: **Ostwald, Robert, Dr-Ing.**
**Hasensteige 8**
**W-7900 Ulm(DE)**

(74) Vertreter: **Schulze, Harald Rudolf, Dipl.-Ing.**
**Licentia Patent-Verwaltungs-GmbH Theodor-Stern-Kai 1**
**W-6000 Frankfurt/Main 70(DE)**

**EP 0 210 437 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur chemischen Metallisierung eines elektrisch schlecht leitenden Trägerkörpers aus einem anorganischen Material nach dem Oberbegriff des Patentanspruchs 1.

Oxidkeramische Materialien wie Aluminiumoxid, Berylliumoxid, Ferrite, Titanate, Zirkonate sowie Quarz, Email und manche Gläser finden in der Elektrotechnik und Elektronik vielfältige Anwendung. Beispiele sind Basismaterialien für Schichtschaltungen (Dick- oder Dünnschichtschaltungen, spezielle Leiterplatten, Hybridschaltungen), Trägerkörper für diskrete Bauelemente (Kondensatoren, Filter, Schwinger, Resonatoren, integrierte Schaltungen u.a.), Bauteile für Sende- und Mikrowellenröhren und transparente Frontplatten für Displays, die mit elektrischen Versorgungs- oder Ansteuerleitungen versehen sind. Andere keramische oder gläserne Materialien werden als Aufbau- oder Trägerkörper oder in Form von Schichten in der Halbleitertechnik eingesetzt. Beispiele hierfür sind Siliciumnitrid und -oxidnitrid sowie carbidische Schichten. Quarzglas und andere Gläser kommen als Lichtwellenleiter in der Lasertechnik und optischen Nachrichtentechnik zum Einsatz und an Berylliumoxid wird seine günstige Wärmeleitfähigkeit bei thermisch beanspruchten Bauteilen geschätzt. Zur Erzeugung der Leiterbahnen und -anschlüsse müssen diese Materialien oder Schichten metallisiert werden, wobei in der Regel Kupfer oder eine Kupferlegierung verwendet wird. Kupfer erfüllt die Anforderungen hinsichtlich elektrischer Leitfähigkeit, Duktilität, Lötbarkeit, stromlos-chemischer Abscheidbarkeit und galvanischer Verstärkbarkeit besonders gut.

Ein schwieriges Problem stellt jedoch die Haftfestigkeit der Kupferauflage auf dem Basismaterial dar, insbesondere wenn dessen Oberfläche aus elektrischen oder optischen Gründen nicht oder nicht in nennenswertem Maße aufgerauht werden darf, so daß in diesem Falle eine mechanische Verankerungsmöglichkeit der Metallschicht auf der meist inerten, abstoßenden und sehr glatten Unterlage nicht gegeben ist. Es ist bekannt, daß bei solchen Gegebenheiten bereits eine sehr dünne Kupferschicht während ihrer Abscheidung im stromlos-chemischen Kupferbad Blasen aufwirft und von der Unterlage abplatzt. Andererseits ist aber gerade die naßchemische Abscheidung ein bevorzugtes Metallisierungsverfahren, da dieses von Format und Geometrie des Werkstücks weitgehend unabhängig ist (im Gegensatz zu Siebdruck-, Aufdampf- oder Sputtertechniken), so daß beispielsweise auch Durch- oder Kantenmetallisierungen im wesentlichen problemlos durchführbar sind.

Zur Lösung dieses Problems sind Verfahren bekannt, die eine haftvermittelnde Zwischenschicht verwenden. Beispiele dafür sind die Verfahren nach den deutschen Patenten DBP 20 04 133 mit Kieselsäure- oder Silicat-Zwischenschicht, DBP 25 33 524 mit Kupferoxid-Zwischenschicht und DBP 24 53 192 mit einem auf die Acidität des Basismaterials abgestimmten sauren oder alkalischen Haftvermittler. Der Wirkmechanismus dieser Haftvermittler besteht vorzugsweise in der Ausbildung chemischer Bindungen zwischen dem Substratmaterial einerseits und der Kupferauflage andererseits. Diese Bindungen kommen im wesentlichen zustande durch Entwässerung, Festkörperdiffusion und/oder -reaktion, weshalb eine thermische Behandlung oder Nachbehandlung die Kinetik dieser Vorgänge und somit den Haftmechanismus günstig beeinflußt. Die prinzipiell erreichbaren Haftfestigkeiten sind sehr hoch und können (als senkrechte Abzugsfestigkeit gemessen) die Zugfestigkeit beispielsweise der Keramik übertreffen. Allerdings ergeben sich bei einer Anwendung Schwierigkeiten derart, daß diese hohen Haftfestigkeitswerte nur punktuell, nämlich an zufällig besonders aktiven Zentren der Substratoberfläche erreicht werden und nicht homogen über die Substratoberfläche hinweg. Das gleiche gilt an Kanten in Substratdurchbrüchen. Insbesondere tritt dieser in nachteiliger Weise Fertigungsausfälle verursachende Effekt bei chemisch inerten Materialien auf, die während der Herstellung einen Hochtemperaturprozeß zu durchlaufen haben und eine Brennhaut enthalten oder durch den Sinterprozeß "totgeglüht" worden sind. In diesen Fällen reicht die übliche Reinigung der Oberfläche z.B. mit organischen Lösemitteln oder verdünnten wäßrigen Reinigungsmitteln auf Tensidbasis oder mit Chromschwefelsäure nicht aus.

Aus IBM Technical Disclosure Bulletin, Band 14, Nr. 10, 1972, Seite 2856 ist es weiterhin bekannt, auf einer gereinigten und sensibilisierten Oberfläche eines Keramiksubstrates stromlos chemisch eine gleichmäßig dicke Kupferoxid-Schicht abzuscheiden und diese bei erhöhter Temperatur und unter reduzierender $H_2$-Atmosphäre in die Substratoberfläche einzubrennen. Auf dieser Schicht erfolgt anschließend eine stromlos chemische Metallabscheidung, z.B. von Cu, Ni oder Au.

Der Erfindung liegt daher die Aufgabe zugrunde, ein gattungsgemäßes Verfahren dahingehend zu verbessern, daß insbesondere bei einem Substrat mit einer sehr glatten Oberfläche in kostengünstiger sowie zuverlässiger Weise eine gleichmäßige haftfeste Metallisierung möglich wird.

Diese Aufgabe wird gelöst durch die im kennzeichnenden Teil des Patentanspruchs 1 angegebenen Merkmale. Zweckmäßige Ausgestaltungen und Weiterbildungen sind den Unteransprüchen entnehmbar.

Die Erfindung beruht auf der Erkenntnis, daß

- es im Gegensatz zu Verfahren gemäß dem Stand der Technik notwendig ist, die Oberfläche eines

Trägerkörpers (Substrat) derart zu aktivieren, daß es dieser möglich ist, über die gesamte aktivierte Oberfläche hinweg mit hoher Dichte chemische Bindungen einzugehen,

- ein Haftvermittler verwendet wird, welcher auf die aktivierte Oberfläche aufgebracht und/oder in eine nachfolgend anfänglich abgeschiedene Metallschicht eingebaut wird, und
- die Ausbildung chemischer Bindungen einschließlich möglicherweise vorgeschalteter Diffusions- und/oder Transportvorgänge durch eine thermische Behandlung vor, während und/oder nach mindestens einem der Verfahrens- schritte beschleunigt sowie verstärkt wird.

Dabei ist besonders zu vermerken, daß die genannten Einzelmerkmale des erfindungsgemäßen Verfahrens für sich allein nicht voll zum gewünschten Erfolg führen, sondern erst deren Kombination. Die Erfindung wird im folgenden anhand von Ausführungsbeispielen näher erläutert.

Der Haftvermittler wird in an sich bekannter Weise, z.B. gemäß dem deutschen Patent DBP 24 53 192, auf das Material sowie die Acidität des aktivierten Trägerkörpers abgestimmt. Die Möglichkeit zur Ausbildung chemischer Bindungen steht bei der Auswahl des Haftvermittlers im Vordergrund. Beispielsweise eignet sich bei hochreinem polykristallinem $Al_2O_3$-Trägermaterial $Cu_2O$ als Haftvermittler, gemäß dem deutschen Patent DBP 25 33 524, da dieser im Rahmen einer Oxidadditionsreaktion feste chemische Bindungen eingeht, wobei in der Grenzschicht eine chemisch sehr widerstandsfähige Verbindung vom Spinell-Typ entsteht nach der Formel:

$$Al_2O_3 + Cu_2O = Cu_2Al_2O_4$$

(vgl. I. Steiner: "Bestimmung der Reaktionsenthalpie für die Oxidaddition $Cu_2O + Al_2O_3 = Cu_2Al_2O_4$ aus Haftfestigkeitsmessungen", Ber. Dtsch. Keram. Ges. 58 (1981) 2, S. 90-92). Bevorzugte thermische Behandlungstemperaturen liegen im Bereich von 300 °C bis 400 °C. Allerdings erfolgt die Gleichgewichtseinstellung - bedingt durch die Reaktionsträgheit des $Al_2O_3$ - selbst bei noch höheren Temperaturen sehr langsam (z.B. bei 900 °C erst nach mehreren Tagen oder gar Wochen). Der Gleichgewichtszustand ist aber anzustreben, wenn über die gesamte Oberfläche hinweg ein Maximum an Haftung erreicht werden soll. Zur Beseitigung dieser kinetischen Hemmung sieht deshalb das erfindungsgemäße Verfahren eine gezielte Substrataktivierung vor, durch die eine chemisch inerte Oberfläche in eine chemisch reaktive Oberfläche umgewandelt wird. Als Lewis-Säure reagierende Substratoberflächen erfordern dabei in der Regel ein alkalisches Medium, als Lewis-Base reagierende Substratoberflächen ein saures Medium. Medium und Aktivierungsbedingungen wie Konzentration des Agens, Temperatur, Druck und Bewegung werden dabei so gewählt, daß das Substrat lediglich in seiner Oberflächenschicht (Glashaut, Brennhaut, inaktive Zonen) abgetragen oder chemisch umgewandelt wird, so daß eine aktive Oberfläche "mit freien Valenzen" gebildet wird. Chemisch ist diese Oberfläche je nach Art des Substratmaterials dadurch charakterisiert, daß beispielsweise unpolare Atomgruppierungen in polare überführt oder störende Fremdatome entfernt werden. Physikalisch gesehen wird durch die Aktivierung eine stark gestörte, energiereiche Oberfläche geschaffen mit zahlreichen Gitterstörungen, Versetzungen, Ecken und Kanten im (sub)-mikrokristallinen Gefüge. Eine Oberflächenaufrauhung im kristallinen Bereich (also im Bereich der Korngröße) wird dagegen weitgehendst ebenso vermieden wie eine Korngrenzenätzung, da diese beispielsweise bei Keramik in störender Weise den Kristallitverbund auflockert. Andererseits erhöht eine oberflächliche Quellung des Gefüges beispielsweise bei glasartigen Substraten die chemische Reaktionsfähigkeit.

Besonders augenfällige Beispiele für die Notwendigkeit der Umwandlung des oberflächlichen Substratmaterials in eine reaktive Oberflächenschicht sind die nichtoxidischen Keramiken. Diese werden erfindungsgemäß beispielsweise durch Hydolysereaktionen in Hydroxid- bzw. Oxidoberflächen umgewandelt, so daß diese dann mit dem Haftvermittler (z.B. $Cu_2O$ im Rahmen von Oxidadditionsreaktionen) weiterreagieren können gemäß den Formeln:

$$BN + H_2O + OH^- = BO(OH) + NH_2^- \quad (\xrightarrow{+H_2O} NH_3)$$

$$2\ AlN + H_2O + 2\ OH^- = Al_2O_3 + 2\ NH_2^- \quad \text{oder}$$

$$AlN + H_2O + OH^- = AlO(OH) + NH_2^- \quad (\xrightarrow{+H_2O} NH_3)$$

$$Si_3N_4 + 6\ H_2O + 4\ OH^- = Si_3O_2(OH)_8 + 4\ NH_2^- \quad (\xrightarrow{+H_2O} NH_3)$$

Auch inerte $Al_2O_3$-Keramik wird auf diese Weise mit frischen und aktiven Kristallflächen ausgestattet, nämlich durch Spaltung von Al-O-Al-Bindungen und Umwandlung in polare endständige Gruppierungen der Form -O-Al-OH bzw. -O-Al-O⁻. Entsprechendes gilt für andere Basismaterialien, die eingangs aufgeführt sind.

Bedingt durch die chemische Reaktionsfähigkeit der oberflächennahen Schicht ist es im allgemeinen notwendig, zur Aktivierung starke Säuren oder Basen einzusetzen, erhöhte Temperaturen, starke Temperaturunterschiede und gelegentlich auch Ultraschallanregung anzuwenden. Beispiele für alkalische Aktivierungsmedien sind heiße gesättigte Natron- oder Kalilauge, Alkalihydroxid- oder -carbonatschmelzen, sowie Druckaufschlüsse mit 30%iger NaOH- oder KOH-Lösung bei 240°C. Durch Zugabe von Komplexbildnern (Mannit, EDTA) kann die Wirksamkeit von Laugen gesteigert werden. Beispiele für saure Medien sind Lösungen oder Schmelzen von Fluoriden (HF, $KHF_2$, $NH_4HF_2$, $HBF_4$), Schmelzgemische aus Borsäure und Fluoriden ($H_3BO_3$ + NaF), heiße konzentrierte Phosphorsäure, Hydrogen- oder Disulfat-Schmelzen.

Das erfindungsgemäße Verfahren wird im folgenden anhand einiger Beispiele näher erläutert, ohne daß es dadurch in irgendeiner Weise eingeschränkt werden soll.

Beispiel 1

Ein Substrat aus hochreiner Aluminiumoxid-Sinterkeramik (>99,6% $Al_2O_3$) in Form eines 0,6 - 0,7mm dicken Plättchens mit mehreren kreisförmigen Durchbrüchen vom Durchmesser 0,5 - 1,0 mm soll zur Herstellung einer Dünnschichtschaltung mit Durchkontaktierungen beidseitig mit 10 µm Kupfer haftfest beschichtet werden. Die Oberflächenrauhigkeit des Keramiksubstrates liegt um 0,1 µm. Nach Vorspülen in entionisiertem Wasser wird das Substrat zur thermischen Aktivierung in einem Röhrenofen an Luft auf 350-400°C erhitzt und zur anschließenden chemischen Aktivierung in eine gesättigte Natriumhydroxid-Lösung von 120°C für 0,1-30s, vorzugsweise 1 s eingetaucht. Der Temperaturunterschied erzeugt auf der Substratoberfläche mechanische Spannungen, die bei einer kurzzeitigen Einwirkung der niedrigen Temperatur sich nur auf die Oberflächenkristallite auswirken, die aber ausreichen, um in der Hydroxidlösung nach dem Mechanismus der Spannungsrißkorrosion inerte Kristallflächen aufzubrechen, insbesondere wenn die Oberflächentemperatur nach dem Herausziehen des Substrats aus der Lauge durch die Wärmekapazität des Substrats wieder ansteigt und/oder das Substrat wieder im Röhrenofen kurzzeitig (1-3 min) auf 350°C erhitzt wird. Nach Abkühlung des Substrats auf Raumtemperatur werden die Natriumhydroxidreste durch Spülen in entionisiertem Wasser entfernt.

Anschließend erfolgt die chemische Verkupferung unter gleichzeitiger Mitabscheidung des Haftvermittlers $Cu_2O$. Dazu wird die Substratoberfläche in bekannter Weise mit Sn/Pd aktiviert und bis zu einer Schichtdicke von 0,5 µm stromlos verkupfert. In diese Kupferschicht werden 5 -10 Gew.-% vorzugsweise 8 Gew.-% $Cu_2O$ eingelagert, und zwar nach einer der in den deutschen Patenten DBP 25 33 524 (vorzugsweise Beispiel 5) oder DBP 29 47 886 (vorzugsweise Beispiel 1 oder 3) aufgeführten Methoden. Zur Ausbildung der eigentlichen Haftvermittlerschicht zwischen $Al_2O_3$ und $Cu_2O$ wird das Substrat dann in Stickstoffatmosphäre 10 min auf 400 °C erhitzt. Nach einer anschließenden galvanischen Verstärkung der Kupferschicht auf 10 µm zeigt die Kupferauflage eine Haftfestigkeit von 2500 - 3000 $N/cm^2$ (im senkrechten Abzugstest), und zwar homogen über die gesamte Substratoberfläche hinweg. Die Haftfestigkeit ist damit größer als die Zugfestigkeit der Keramik selbst.

Beispiel 2

Der Herstellungsgang für die haftfeste Verkupferung eines $Al_2O_3$-Substrates ist der gleiche wie in Beispiel 1, jedoch mit dem Unterschied, daß thermische und chemische Aktivierung gleichzeitig erfolgen, nämlich durch Eintauchen des Substrats in eine 350 °C heiße Schmelze von Natriumhydroxid mit einer Dauer von 1 - 10 min (vorzugsweise 3 min).

Beispiel 3

Anstelle eines $Al_2O_3$-Substrats wird ein Trägerkörper aus Bornitrid eingesetzt. Zur haftfesten Metallisierung wird die nitridische Oberfläche in eine oxidische bzw. oxidnitridische Oberfläche umgewandelt, um sie dem Haftvermittler $Cu_2O$ anzupassen. Der Trägerkörper wird dazu in eine 120 °C heiße, gesättigte Natriumhydroxidlösung eingetaucht, der 1 - 10 g/l (vorzugsweise 3 g/l) Mannit zugesetzt wurden. Die Dauer dieser Behandlung richtet sich nach der jeweils vorliegenden Inaktivität des Substratmaterials, die je nach Herstellungscharge beträchtlichen Schwankungen unterworfen sein kann. Als Richtwert wird eine durchschnittliche Dauer von 5 min angegeben, um mehrere Atomlagen des Nitrids in Oxid oder Oxidnitrid (unter Ammoniakbildung) umzuwandeln. Ist diese Aktivierung bei besonders reaktionsträgen Substratchargen nicht ausreichend, so wird entweder die Mannitkonzentration erhöht oder eine Alkalihydroxidschmelze eingesetzt. Ansonsten werden die Verkupferung und die thermische Nachbehandlung wie in Beispiel 1 durchgeführt.

Beispiel 4

Ein planares Substrat aus sogenannter schwarzer Keramik, z.B. einem Mangan-Zink-Ferrit, wird oberflächenaktiviert durch Tauchen in konzentrierte Phosphorsäure, die knapp unterhalb des Siedepunktes gehalten wird (z.B. 85 Gew.-% $H_3PO_4$ bei 150 °C). Als Dauer der Aktivierungsbehandlung reichen in den meisten Fällen etwa 10 min aus. Als Haftvermittler dient $Cu_2O$ oder amorphe Kieselsäure. Letztere wird nach dem deutschen Patent 20 04 133 (vorzugsweise Beispiel 3) auf das Substrat aufgebracht, das anschließend an die 0,5 $\mu$m dicke stromlose Verkupferung für 15 min unter Schutzgas auf 400 °C erhitzt wird. Die erreichte Haftfestigkeit des 10 $\mu$m dicken Kupfers übertrifft die Bruchfestigkeit der Keramik auf der ganzen Oberfläche.

Beispiel 5

Ein sehr glattes Substrat aus Quarzglas wird zunächst auf etwa 500 °C erhitzt und anschließend Langsam in eine 30%ige KOH-Lösung getaucht. Durch die gleichzeitige Einwirkung von sich bildendem Wasserdampf und Hydroxiddionen in der Abkühlphase erfolgt eine oberflächliche "Pyrohydrolyse" des Quarzglases, die das Si-O-Si-Gerüst aufschließt und aufquellt, so daß für den Haftvermittler $Cu_2O$ eine hinreichend aktive Oberfläche zur Verfügung steht. Nach dem Abkühlen erfolgt die weitere Behandlung des QuarzglasSubstrats nach Beispiel 1.

**Patentansprüche**

**1.** Verfahren zur chemischen Metallisierung eines elektrisch schlecht leitenden Trägerkörpers aus einem anorganischen Material, insbesondere zur naßchemischen Verkupferung eines Trägerkörpers aus Keramik, Glas, Email oder anderem oxidischem, nitridischem, carbidischem, silicidischem, boridischem Material oder aus Mischungen oder Mischverbindungen aus diesen anorganischen Materialien, bei welchem

- auf der gereinigten Trägerkörperoberfläche, ggf. nach Aufbringen einer Sn/Pd-Aktivierungsschicht, eine Schicht eines anorganischen Haftvermittlers erzeugt wird, welcher eine Haftvermittlung zwischen der Trägerkörperoberfläche und einer nachfolgend aufgebrachten Metallschicht, insbesondere einer Cu-Schicht ermöglicht, und
- eine thermische Behandlung erfolgt, welche aufgrund von Diffusion- und/oder Transportvorgängen eine haftfeste Verbindung zumindest zwischen der Trägerkörperoberfläche und dem Haftvermittler bewirkt, dadurch gekennzeichnet,

daß vor dem Erzeugen der Haftvermittlerschicht bzw. ggf. vor dem Aufbringen der Sn/Pd-Aktivierungsschicht die Trägerkörperoberfläche durch eine an dessen Material angepaßte Aktivierung so aufbereitet wird, daß eine chemisch hochreaktive Trägerkörperoberfläche mit freien Valenzen, die eine hohe Flächendichte besitzen, entsteht, wobei bei einer als Lewis-Säure reagierenden Trägerkörperoberfläche ein alkalisches Medium und bei einer als Lewis-Base reagierenden Trägerkörperoberfläche ein saures Medium zur Aktivierung verwendet wird, und wobei bei Vorliegen einer nichtoxidischen Trägerkörperoberfläche diese durch die Aktivierung in eine oxidische Oberfläche umgewandelt wird.

2. Verfahren nach Anspruch 1, dadurch gekennzeichnet, daß als alkalisches Medium eine heiße gesättigte Alkalilauge, eine Alkalihydroxid-Schmelze, eine Alkalicarbonat-Schmelze, eine heiße Alkalihydroxid-Lösung unter Druck, eine Alkalihydroxid-Lösung mit Komplexbildner-Zusatz oder eine weitere alkalisch reagierende Lösung oder Schmelze verwendet wird.

3. Verfahren nach einem der Ansprüche 1 bis 2, dadurch gekennzeichnet, daß als saures Medium heiße Phosphorsäure, ein Phosphorsäure-Schwefelsäure-Gemisch, eine fluoridhaltige Lösung oder Schmelze, eine Alkalihydrogen- oder -disulfatschmelze verwendet wird.

4. Verfahren nach einem der vorhergehenden Ansprüche, dadurch gekennzeichnet, daß als Haftvermittler Kupferoxid oder Kieselsäure oder ein Silicat verwendet wird.

5. Verfahren nach Anspruch 4, dadurch gekennzeichnet, daß als Haftvermittler Kupfer(I)-oxid verwendet wird.

6. Verfahren nach einem der vorhergehenden Ansprüche, dadurch gekennzeichnet, daß eine thermische Behandlung vor, während oder nach mindestens einem der Verfahrensschritte im Temperaturbereich von 100 ° C bis 500 ° C durchgeführt wird.

**Claims**

1. Method for the chemical metallising of an electrically poorly conducting carrier body of an inorganic material, in particular for the wet chemical copper-plating of a carrier body of ceramic, glass, enamel or other oxidic, nitridic, carbidic, silicidic or boridic material or of mixtures or mixed compounds of these inorganic materials, in which method
   - a layer of an inorganic adhesive agent is produced on the cleaned carrier body surface, in a given case after application of an Sn/Pd activating layer, which agent enables an adhesion between the carrier body surface and a subsequently applied metal layer, in particular a Cu layer, and
   - a thermal treatment follows, which by reason of diffusion and/or transport processes effects a tenacious connection at least between the carrier body surface and the adhesive agent, characterised thereby,

   that before the production of the layer of adhesive agent or in a given case before the application of the Sn/Pd activating layer, the carrier body surface is so prepared by an activation adapted to its material that a chemically highly reactive carrier body surface arises with free valencies which possess a high surface density, wherein an alkaline medium is used for activation in the case of a carrier body surface reacting as Lewis acid and an acidic medium is used for activation in the case of a carrier body surface reacting as Lewis base and wherein on the presence of a non-oxidic carrier body surface, this is converted by the activation into an oxidic surface.

2. Method according to claim 1, characterised thereby, that a hot saturated lye, an alkali hydroxide bath, an alkali carbonate bath, a hot alkali hydroxide solution under pressure, an alkali hydroxide solution with complexing agent additive or a further alkalinely reacting solution or bath is used as alkaline medium.

3. Method according to one of the claims 1 and 2, characterised thereby, that hot phosphoric acid, a mixture of phosphoric acid and sulphuric acid, a solution or bath containing fluoride or a bath of alkali hydrogen or alkali disulphate is used as acidic medium.

4. Method according to one of the preceding claims, characterised thereby, that copper oxide or silicic acid or a silicate is used as adhesive agent.

5. Method according to claim 4, characterised thereby, that cuprous oxide is used as adhesive agent.

6. Method according to one of the preceding claims, characterised thereby, that a thermal treatment is performed in the temperature range of 100 ° C to 500 ° C before, during or after at least one of the method steps.

**Revendications**

1. Procédé de métallisation chimique d'un support en matériau inorganique faiblement conducteur de l'électricité, notamment de cuivrage chimique par voie humide d'un support en céramique, verre, émail ou autre matériau oxydé, nitruré, carburé, siliciuré, boruré ou en mélanges ou composés mixtes de ces matériaux inorganiques, dans lequel
   - est engendrée sur la surface nettoyée du support, le cas échéant après application d'une couche d'activation au Sn/Pd, une couche d'un adhésif inorganique permettant une adhésion entre la surface du support et une couche métallique appliquée ulté-rieurement, notamment une couche de Cu, et
   - est opéré un traitement thermique qui crée, par suite d'opérations de diffusion et/ou de transport,une liaison adhésive au moins entre la surface du support et l'adhésif, caractérisé en ce que, préalablement à la génération de la couche d'adhésif ou le cas échéant à l'application de la couche d'activation au Sn/Pd, la surface du support est préparée par une activation adaptée à son matériau, de telle sorte que se forme une surface de support chimiquement très réactive à valences libres possédant une forte densité superficielle, un milieu alcalin étant utilisé pour l'activation dans le cas d'une surface de support réagissant comme un acide de Lewis et un milieu acide dans le cas d'une surface de support réagissant comme une base de Lewis et une surface de support non oxydée éventuelle étant transformée par activation en une surface oxydée.

2. Procédé selon la revendication 1, caractérisé en ce que l'on utilise comme milieu alcalin une lessive alcaline chaude saturée, un hydroxyde alcalin fondu, un carbonate alcalin fondu, une solution chaude d'hydroxyde alcalin sous pression, une solution d'hydroxyde alcalin additionnée de complexants ou une autre solution ou masse fondue à réaction alcaline.

3. Procédé selon l'une des revendications 1 à 2, caractérisé en ce que l'on utilise comme milieu acide de l'acide phosphorique chaud, un mélange d'acide phosphorique et d'acide sulfurique, une solution ou une masse fondue contenant des fluorures, des masses fondues d'hydrogénosulfates ou de bisulfates alcalins.

4. Procédé selon l'une des revendications précédentes, caractérisé en ce que l'on utilise comme adhésifs de l'oxyde de cuivre ou de l'acide silicique ou un silicate.

5. Procédé selon la revendication 4, caractérisé en ce que l'on utilise comme adhésif de l'oxyde de cuivre(I).

6. Procédé selon l'une des revendications précédentes, caractérisé en ce que l'on procède à un traitement thermique avant, pendant ou après au moins une des étapes du procédé dans une plage de températures comprises entre de 100 °C et 500 °C.